# EUROPEAN PATENT SPECIFICATION

(11) **EP 2 088 221 B1**
(45) Date of publication and mention of the grant of the patent: **17.12.2014**
(21) Application number: 09250282.2
(22) Date of filing: 04.02.2009
(51) Int. Cl.: C23C 16/26, H01M 4/52, H01M 4/58

(54) **Non-aqueous electrolyte secondary battery negative electrode material, making method, lithium ion secondary battery, and electrochemical capacitor**
Material für die Negativelektrode einer Sekundärbatterie mit nichtwässrigem Elektrolyt, Herstellungsverfahren, Lithiumionensekundärbatterie und elektrochemischer Kondensator
Matériau d'électrode négative de batterie secondaire à électrolyte non aqueux, procédé de fabrication, batterie secondaire au ion lithium et condensateur électrochimique

(30) Priority: 07.02.2008 JP 2008027357; 16.06.2008 JP 2008156653
(43) Date of publication of application: 12.08.2009
(73) Proprietor: Shin-Etsu Chemical Co., Ltd., Tokyo (JP)
(72) Inventor: Fukuoka, Hirofumi, Annaka-shi, Gunma-ken (JP); Miyawaki, Satoru, Annaka-shi, Gunma-ken (JP); Kashida, Meguru, Annaka-shi, Gunma-ken (JP); Ohba, Toshio, Annaka-shi, Gunma-ken (JP)
(74) Representative: Stoner, Gerard Patrick

(56) References cited:
- EP-A- 1 363 341
- DE-A1-102005 011 940
- US-A1- 2005 164 090

## Description

This invention relates to a non-aqueous electrolyte secondary battery negative electrode material which exhibits a high charge/discharge capacity and satisfactory cycle performance when used as the negative electrode active material in lithium ion secondary batteries, a method for preparing the same, a lithium ion secondary battery, and an electrochemical capacitor.

### BACKGROUND

With the recent remarkable development of portable electronic equipment, communications equipment and the like, a strong demand for high energy density secondary batteries exists from the standpoints of economy and size and weight reductions. One prior art method for increasing the capacity of secondary batteries is to use oxides as the negative electrode material, for example, oxides of V, Si, B, Zr, Sn or the like or complex oxides thereof (see JP-A 5-174818 and JP-A 6-060867), metal oxides quenched from the melt (JP-A 10-294112), silicon oxide (Japanese Patent No. 2,997,741), and Si₂N₂O and Ge₂N₂O (JP-A 11-102705). Conventional methods of imparting conductivity to the negative electrode material include mechanical alloying of SiO with graphite, followed by carbonization (see JP-A 2000-243396), coating of silicon particles with a carbon layer by chemical vapor deposition (JP-A 2000-215887), and coating of silicon oxide particles with a carbon layer by chemical vapor deposition (JP-A 2002-42806).

These prior art methods are successful in increasing the charge/discharge capacity and energy density, but are not necessarily satisfactory because of insufficient cycle performance and failure to fully meet the characteristics required in the market. There is a desire for further improvement in energy density.

In particular, Japanese Patent No. 2,997,741 uses silicon oxide as the negative electrode material in a lithium ion secondary battery to provide an electrode with a high capacity. As long as the present inventors have confirmed, there is left a room for further improvement as demonstrated by a still high irreversible capacity on the first charge/discharge cycle and cycle performance below the practical level. With respect to the technique of imparting conductivity to the negative electrode material, JP-A 2000-243396 suffers from the problem that solid-to-solid fusion fails to form a uniform carbon coating, resulting in insufficient conductivity. In the method of JP-A 2000-215887 which can form a uniform carbon coating, the negative electrode material based on silicon undergoes excessive expansion and contraction upon adsorption and desorption of lithium ions, and is thus impractical. Since the cycle performance lowers, the charge/discharge quantity must be limited in order to prevent the cycle performance from degrading. In JP-A 2002-42806, despite a discernible improvement of cycle performance, due to precipitation of silicon crystallites, insufficient structure of the carbon coating and insufficient fusion of the carbon coating to the substrate, the capacity gradually lowers as charge/discharge cycles are repeated, and suddenly drops after a certain number of charge/discharge cycles. This approach is thus insufficient for use in secondary batteries.

An object of the present invention is to provide new and useful non-aqueous electrolyte secondary battery negative electrode materials from which negative electrodes having good or improved cycle performance for lithium ion secondary batteries can be prepared. Aspects of our proposals include methods for preparing such materials and electrodes, also corresponding lithium ion secondary batteries and electrochemical capacitors.

The inventors found that a significant improvement in battery performance is achieved by coating particles of a lithium ion-occluding and releasing material on their surface with a graphite coating, but a general graphite coating still fails to meet the characteristics required in the market. Continuing efforts to further improve battery characteristics, the inventors have found that a better performance level can be provided by controlling the specific properties of a graphite coating covering surfaces of a lithium ion-occluding and releasing material.

In the course of research work, the inventors evaluated the battery characteristics of materials obtained by covering surfaces of lithium ion-occluding and releasing materials with a graphite coating under different sets of conditions and found that the battery characteristics differ with different materials. Analyzing a number of coated materials, the inventors have found that a negative electrode material having appropriate characteristics for use in non-aqueous electrolyte secondary batteries is obtained by limiting the battery characteristics and the type of graphite as the coating within a certain range. A method for preparing the negative electrode material has been established.

In one aspect, the invention provides a negative electrode material for non-aqueous electrolyte secondary batteries, comprising a conductive powder of particles of a lithium ion-occluding and releasing material coated on their surface with a graphite coating, wherein the graphite coating, on Raman spectroscopy analysis, develops broad peaks having an intensity I₁₃₃₀ and I₁₅₈₀ at 1330 cm⁻¹ and 1580 cm⁻¹ Raman shift, an intensity ratio I₁₃₃₀/I₁₅₈₀ being 1.5 < I₁₃₃₀/I₁₅₈₀ < 3.0.

In a preferred embodiment, the lithium ion-occluding and releasing material is silicon, composite particles having silicon grains dispersed in a silicon compound, silicon oxide of the general formula SiOₓ wherein 0.5 s x < 1.6, or a mixture thereof.

In a preferred embodiment, particles of the lithium ion-occluding and releasing material have whiskers on their surface.

Another aspect is a method for preparing a negative electrode material, typically as defined above, comprising effecting chemical vapor deposition in an organic gas and/or vapor under a reduced pressure of 50 Pa to 30,000 Pa and at a temperature of 1,000 to 1,400°C on particles of a lithium ion-occluding and releasing material, thereby coating the particles on their surface with a graphite coating.

The lithium ion-occluding and releasing material is preferably silicon, composite particles having silicon grains dispersed in a silicon compound, silicon oxide of the general formula SiOₓ wherein 0.5 s x < 1.6, or a mixture thereof.

A lithium ion secondary battery comprising the negative electrode material defined above is provided as well as an electrochemical capacitor comprising the negative electrode material.

### BENEFITS

Using negative electrode materials as proposed herein as a lithium ion secondary battery negative electrode material, we find that secondary batteries having a high capacity and improved cycle performance can be manufactured. The method of preparing the negative electrode material is simple and applicable to the industrial scale production.

### BRIEF DESCRIPTION OF THE DRAWINGS

FIG. 1 is a Raman spectroscopy diagram of Example 1 and Comparative Examples 1 and 2.
FIG. 2 is a SEM photograph of a conductive powder in Example 1.
FIG. 3 is a SEM photograph of a conductive powder in Comparative Example 1.

### FURTHER EXPLANATIONS; OPTIONS AND PREFERENCES

As used herein, the term "conductive" or "conductivity" refers to electrically conductive or electric conductivity.

The lithium ion-occluding and releasing materials used herein include
silicon-base substances such as metallic silicon, particles of composite microstructure having silicon grains dispersed in a silicon compound, lower oxides of silicon (generally referred to as silicon oxide), and mixtures thereof, typically silicon (Si), a composite dispersion of silicon (Si) and silicon dioxide (SiO₂), and silicon oxides SiOₓ wherein 0.5 ≤ x < 1.6, preferably 1.0 s x < 1.6, and more preferably 0.8 s x < 1.3;
silicon-free metal oxides represented by the formula: MOₐ wherein M is at least one metal selected from among Ge, Sn, Pb, Bi, Sb, Zn, In and Mg and "a" is a positive number of 0.1 to 4; and
lithium complex oxides (which may contain silicon) represented by the formula: LiM_{b}O_{c} wherein M is at least one metal selected from among Ge, Sn, Pb, Bi, Sb, Zn, In, Mg and Si, b is a positive number of 0.1 to 4, and c is a positive number of 0.1 to 8.

Specific examples include GeO, GeO₂, SnO, SnO₂, Sn₂O₃, Bi₂O₃, Bi₂O₅, Sb₂O₃, Sb₂O₄, Sb₂O₅, ZnO, In₂O, InO, In₂O₃, MgO, Li₂SiO₃, Li₄SiO₄, Li₂Si₃O₇, Li₂Si₂O₅, Li₈SiO₆, Li₆S₂O₇, Li₄Ge₉O₇, Li₄Ge₉O₂, Li₅Ge₈O₁₉, Li₄Ge₅O₁₂, Li₅Ge₂O₇, Li₄GeO₄, Li₂Ge₇O₁₅, Li₂GeO₃, Li₂Ge₄O₉, Li₂SnO₃, Li₈SnO₆, Li₂PbO₃, Li₇SbO₅, LiSbO₃, Li₃SbO₄, Li₃BiO₅, Li₆BiO₆, LiBiO₂, Li₄Bi₆O₁₁, Li₆ZnO₄, Li₄ZnO₃, Li₂ZnO₂, LiInO₂, Li₃InO₃, and analogous non-stoichiometric compounds. The invention becomes more effective when metallic silicon (Si), particles of composite microstructure having silicon grains dispersed in a silicon compound, and silicon oxides having a high theoretical charge/discharge capacity are used.

No particular limits are imposed on the physical properties of silicon (Si) and particles of composite microstructure having silicon grains dispersed in a silicon compound. Preferably they are in the form of particles having an average particle size of about 0.01 to 50 µm, especially about 0.1 to 10 µm. If the average particle size is less than 0.01 µm, purity lowers owing to surface oxidation and on use as the lithium ion secondary battery negative electrode material, there may result a lowering of charge/discharge capacity, a lowering of bulk density, and a lowering of charge/discharge capacity per unit volume. If the average particle size is more than 50 µm, a smaller amount of graphite may deposit thereon during chemical vapor deposition treatment, which may eventually lead to cycle performance lowering on use as the lithium ion secondary battery negative electrode material.

It is noted that the average particle size can be determined as the weight average particle size in a particle size distribution as measured by the laser light diffraction method.

In the particles of composite microstructure having silicon grains dispersed in a silicon compound, the silicon compound should preferably be inert, and is typically silicon dioxide because of ease of preparation. The composite microstructure particles should preferably have the following characteristics.
(i) On analysis by x-ray diffraction (Cu-Kα) using copper as the counter cathode, a diffraction peak attributable to Si(111) and centering near 26 = 28.4° is observed, and silicon crystals have a grain size of 1 to 500 nm, more preferably 2 to 200 nm, and even more preferably 2 to 20 nm as determined by Scherrer equation based on the spread of the diffraction peak. A silicon grain size of less than 1 nm may lead to a lowering of charge/discharge capacity whereas a silicon grain size of more than 500 nm may lead to substantial expansion and contraction during charge/discharge operation and a lowering of cycle performance. The size of silicon grains can be measured on the basis of a photomicrograph under transmission electron microscope (TEM).
(ii) On analysis by solid-state NMR (²⁹Si-DDMAS), a broad peak of silicon dioxide centering at approximately -110 ppm and a peak characteristic of Si diamond-type crystals near -84 ppm appear in the spectrum. This spectrum is entirely different from that of ordinary silicon oxide (SiOx wherein x = 1.0+α), indicating a definitely different structure. It is confirmed by TEM observation that silicon crystals are dispersed in amorphous silicon dioxide.

In the silicon/silicon dioxide (Si/SiO₂) dispersion, the amount of silicon grains dispersed is preferably 2 to 36%, and more preferably 10 to 30% by weight. Less than 2 wt% of silicon grains dispersed may lead to a lower charge/discharge capacity whereas more than 36 wt% may lead to a poorer cycle performance.

The method of preparing the particles of composite microstructure having silicon grains (or crystallites) dispersed in a silicon compound, sometimes referred to as "composite silicon powder," is not particularly limited as long as the composite silicon powder preferably has an average particle size of 0.01 to 50 µm. Preferably, the composite silicon powder is prepared by heat treating a silicon oxide powder of the general formula: SiOx wherein x is 0.5 ≤ x < 1.6, and preferably 1.0 ≤ x < 1.6, in an inert gas atmosphere at a temperature in the range of 900 to 1400°C for inducing disproportionation.

As used herein, the term "silicon oxide" generally refers to amorphous silicon oxides obtained by heating a mixture of silicon dioxide and metallic silicon to produce a silicon monoxide gas and cooling the gas for precipitation. The silicon oxide powder used herein is represented by the general formula: SiOx wherein x is 0.5 ≤ x < 1.6, preferably 1.0 s x < 1.6, even more preferably 0.8 ≤ x < 1.3, and most preferably 0.8 ≤ x ≤ 1.2 and preferably has an average particle size of at least 0.01 µm, more preferably at least 0.1 µm, even more preferably at least 0.5 µm, and up to 30 µm, more preferably up to 20 µm. The silicon oxide powder preferably has a BET specific surface area of at least 0.1 m²/g, more preferably at least 0.2 m²/g and up to 30 m²/g, more preferably up to 20 m²/g. If the average particle size and BET surface area of silicon oxide powder are outside the ranges, a composite silicon powder having the desired average particle size and BET surface area may not be obtained. It is difficult to prepare SiOx powder wherein x < 0.5. If x ≥ 1.6, heat treatment to induce disproportionation reaction may result in an increased content of inert SiO₂, and on use of the resulting powder in lithium ion secondary batteries, the charge/discharge capacity may become low.

In disproportionation of silicon oxide, a heat treatment temperature below 900°C may be inefficient because disproportionation does not take place at all or formation of minute cells or crystallites of silicon becomes time-consuming. If the temperature is above 1,400°C, the structuring of silicon dioxide proper is promoted to such an extent as to impede motion of lithium ions, leaving a risk of damaging the function as a lithium ion secondary battery. The preferred heat treatment temperature is 1,000 to 1,300°C, especially 1,100 to 1,250°C. The treatment (or disproportionation) time may be selected in the range of 10 minutes to 20 hours, especially 30 minutes to 12 hours, depending on the treatment temperature. At a treatment temperature of 1,100°C, for example, a composite silicon powder (disproportionated product) having the desired physical properties is obtained within a time of about 5 hours.

For the disproportionation, any desired reactor having a heating mechanism may be used in an inert gas atmosphere. Depending on a particular purpose, a reactor capable of either continuous or batchwise treatment may be selected from, for example, a fluidized bed reactor, rotary furnace, vertical moving bed reactor, tunnel furnace, batch furnace and rotary kiln. The treating gas used herein may be a gas which is inert at the treatment temperature, such as Ar, He, H₂ or N₂ or a mixture thereof.

The negative electrode material for non-aqueous electrolyte secondary batteries is a powder consisting of particles of the above-described lithium ion-occluding and releasing material coated on their surface with a graphite coating. The coating method is preferably chemical vapor deposition (CVD).

Now the graphite coating and the conductive powder having graphite coating are described.

The amount of graphite coating covering surfaces of lithium ion-occluding and releasing material particles is not particularly limited, and is preferably 0.3 to 40% by weight, and more preferably 0.5 to 30% by weight based on the weight of lithium ion-occluding and releasing material. If the amount of graphite coating is less than 0.3 wt%, a sufficient conductivity may not be maintained and the resulting negative electrode material may provide unsatisfactory cycle performance when assembled in a non-aqueous electrolyte secondary battery. If the amount of graphite coating is more than 40 wt%, no further improvement is observed, and the resulting negative electrode material having an increased content of graphite may provide unsatisfactory cycle performance when assembled in a non-aqueous electrolyte secondary battery.

It is important to select the type of graphitic material that covers surfaces of lithium ion-occluding and releasing material and control the proportion of graphitic components within a certain range. In general, graphitic materials are classified into three allotropies, diamond, graphite, and amorphous carbon. These graphitic materials have their own physical properties. Specifically, diamond has a high strength, high density and high insulation, and graphite has good electrical conductivity. As the graphite material that covers surfaces of lithium ion-occluding and releasing material, a graphitic material having diamond structure and a graphitic material having graphite structure are mixed in an optimum proportion so as to gain an optimum combination of the respective characteristics, resulting in a negative electrode material capable of preventing failure by expansion and contraction during charge/discharge cycles and having a conductive network.

The proportion of the graphitic material having diamond structure and the graphitic material having graphite structure may be determined by Raman spectroscopy analysis, i.e., on the basis of a Raman spectrum. More specifically, since diamond develops a sharp peak at 1330 cm⁻¹ Raman shift and graphite develops a sharp peak at 1580 cm⁻¹ Raman shift, the proportion of the two graphitic components may be simply determined from a ratio of peak intensities.

The inventors have found that when a negative electrode material having a graphite coating which on Raman spectroscopy analysis, develops a peak having an intensity I₁₃₃₀ at 1330 cm⁻¹ Raman shift and a peak having an intensity I₁₅₈₀ at 1580 cm⁻¹ Raman shift, wherein an intensity ratio I₁₃₃₀/I₁₅₈₀ is in the range: 1.5 < I₁₃₃₀/I₁₅₈₀ < 3.0, and preferably 1.7 < I₁₃₃₀/I₁₅₈₀ < 2.5 is used as a lithium ion secondary battery negative electrode material, a lithium ion secondary battery having good battery performance is obtained, so that these are preferred parameters for the coating.

If the proportion of graphite structure material is so high as to provide an intensity ratio I₁₃₃₀/I₁₅₈₀ equal to or less than 1.5, the graphite coating has a reduced strength so that electrode failure may occur due to expansion and contraction of electrode material during charging/discharging cycles, leading to a lowering of battery capacity and degradation of cycle performance on repeated use. If the proportion of diamond structure material is so high as to provide an intensity ratio I₁₃₃₀/I₁₅₈₀ equal to or more than 3.0, there result a loss of conductivity and a lowering of cycle performance.

A preferred electrode material can therefore be defined as comprising a conductive powder consisting of particles of a lithium ion-occluding and releasing material coated on their surface with a graphite coating, wherein the graphite coating, on Raman spectroscopy analysis, develops broad peaks having an intensity I₁₃₃₀ and I₁₅₈₀ at 1330 cm⁻¹ and 1580 cm⁻¹ Raman shift, an intensity ratio I₁₃₃₀/I₁₅₈₀ being 1.5 < I₁₃₃₀/I₁₅₈₀ < 3.0. In a preferred embodiment, the particles of the lithium ion-occluding and releasing material have whiskers on their surface. In this embodiment, particle surfaces and whiskers are covered with the graphite coating.

In Japanese Patent No. 3952180 (USP 7,037,581, EP 1363341A2, CN 1513922), the Applicant already proposed: "A conductive silicon composite for use as a non-aqueous electrolyte secondary cell negative electrode material in which particles of the structure that crystallites of silicon are dispersed in a silicon compound are coated on their surfaces with carbon wherein when analyzed by x-ray diffractometry, a diffraction peak attributable to Si(111) is observed, and the silicon crystallites have a size of 1 to 500 nm as determined from the half width of the diffraction peak by Scherrer method." This silicon composite is prepared by heat treating silicon oxide in an organic gas and/or vapor at 900 to 1,400°C and atmospheric pressure for disproportionation, and no whiskers are formed on this silicon composite.

The whiskers are formed of silicon, silicon oxide, silicon crystallites dispersed in a silicon compound, or a mixture thereof. Preferably the whiskers have a length of 0.01 to 30 µm, and more preferably 0.1 to 10 µm. Whiskers shorter than 0.01 µm may contribute less to current collection whereas whiskers longer than 30 µm may be broken during electrode formation. Preferably the whiskers have an (equivalent) diameter of 0.001 to 1 µm, and more preferably 0.01 to 0.1 µm. Whiskers thinner than 0.001 µm may have insufficient strength whereas whiskers thicker than 1 µm may not exert the desired effect. A proportion of whiskers in the conductive powder is preferably 0.001 to 10% by weight, and more preferably 0.01 to 5% by weight.

Next, the method for preparing the negative electrode material is described. The negative electrode material is prepared by effecting chemical vapor deposition in an organic gas and/or vapor under a reduced pressure of up to 30,000 Pa and at a temperature of 1,000 to 1,400°C on particles of a lithium ion-occluding and releasing material, thereby coating the particles on their surface with a graphite coating. The treatment temperature is 1,000 to 1,400°C, and preferably 1,020 to 1,200°C. If the treatment temperature is below 1,000°C, the graphite coating step may be difficult and require a long time. If the treatment temperature is above 1,400°C, particles may be fused and agglomerated during chemical vapor deposition, avoiding formation of a conductive coating at the agglomerated interface and resulting in a negative electrode material having poor cycle performance. Particularly when silicon is used as the matrix, that temperature is close to the melting point of silicon, so that silicon may melt, inhibiting coverage of particle surfaces with a conductive coating.

The treatment time may be determined as appropriate depending on the graphite buildup, treatment temperature, and the concentration (or flow rate) and quantity of organic gas. Usually a treatment time of 1 to 10 hours, especially 2 to 7 hours is employed for efficiency and economy.

The organic material to generate the organic gas is selected from those materials capable of producing carbon (graphite) through pyrolysis at the heat treatment temperature, especially in a non-oxidizing atmosphere. Exemplary are hydrocarbons such as methane, ethane, ethylene, acetylene, propane, butane, butene, pentane, isobutane, and hexane alone or in admixture of any, and monocyclic to tricyclic aromatic hydrocarbons such as benzene, toluene, xylene, styrene, ethylbenzene, diphenylmethane, naphthalene, phenol, cresol, nitrobenzene, chlorobenzene, indene, coumarone, pyridine, anthracene, and phenanthrene alone or in admixture of any. Also, gas light oil, creosote oil and anthracene oil obtained from the tar distillation step are useful as well as naphtha cracked tar oil, alone or in admixture.

In order to deposit a graphite coating on surfaces of lithium ion-occluding and releasing material, it is important that the treatment be effected under a reduced pressure of 50 to 30,000 Pa, preferably 100 to 20,000 Pa, and more preferably 1,000 to 20,000 Pa. If the reduced pressure is less than 50 Pa, the proportion of diamond structure graphitic material becomes higher, leading to losses of conductivity and cycle performance on use as the lithium ion secondary battery negative electrode material. If the pressure is more than 30,000 Pa, the proportion of graphite structure graphitic material becomes too higher, leading to losses of cell capacity and cycle performance on use as the lithium ion secondary battery negative electrode material.

The conductive powder consisting of particles of a lithium ion-occluding and releasing material having whiskers on surfaces may be prepared by effecting chemical vapor deposition in an organic gas and/or vapor under a reduced pressure of 50 to 30,000 Pa and at a temperature of 1,000 to 1,400°C, especially 1,000 to 1,300°C on particles of a lithium ion-occluding and releasing material, especially silicon, composite particles having silicon grains dispersed in a silicon compound, silicon oxide of the general formula SiOₓ wherein 0.5 s x < 1.6, especially 1.0 ≤ x < 1.6, or a mixture thereof.

According to the invention, the composite silicon powder may be used as a negative electrode material to construct a non-aqueous electrolyte secondary battery, especially a lithium ion secondary battery.

The lithium ion secondary battery thus constructed is characterized by the use of the composite silicon powder as the negative electrode material while the materials of the positive electrode, negative electrode, electrolyte, and separator and the cell design are not particularly limited and may be well-known ones. For example, the positive electrode active material used herein may be selected from transition metal oxides such as LiCoO₂, LiNiO₂, LiMn₂O₄, V₂O₅, MnO₂, TiS₂ and MoS₂ and chalcogen compounds. The electrolytes used herein may be lithium salts such as lithium perchlorate in non-aqueous solution form. Examples of the non-aqueous solvent include propylene carbonate, ethylene carbonate, dimethoxyethane, γ-butyrolactone and 2-methyltetrahydrofuran, alone or in admixture. Use may also be made of other various non-aqueous electrolytes and solid electrolytes.

When a negative electrode is prepared using the inventive composite silicon powder, a conductive agent such as graphite may be added to the powder. The type of conductive agent used herein is not particularly limited as long as it is an electronically conductive material which does not undergo decomposition or alteration in the battery. Illustrative conductive agents include metals in powder or fiber form such as Al, Ti, Fe, Ni, Cu, Zn, Ag, Sn and Si, natural graphite, synthetic graphite, various coke powders, meso-phase carbon, vapor phase grown carbon fibers, pitch base carbon fibers, PAN base carbon fibers, and graphite obtained by firing various resins.

A further embodiment is an electrochemical capacitor which is characterized by comprising the composite silicon powder as an electrode active material, while other materials such as electrolyte and separators and capacitor design are not particularly limited. Examples of the electrolyte used include non-aqueous solutions of lithium salts such as lithium hexafluorophosphate, lithium perchlorate, lithium borofluoride, and lithium hexafluoroarsenate, and examples of non-aqueous solvents include propylene carbonate, ethylene carbonate, dimethyl carbonate, diethyl carbonate, dimethoxyethane, γ-butyrolactone, and 2-methyltetrahydrofuran, alone or a combination of two or more. Other various non-aqueous electrolytes and solid electrolytes may also be used.

### EXAMPLE

Examples of the invention are given below by way of illustration and not by way of limitation.

### Example 1

A batchwise heating furnace was charged with 200 g of silicon oxide powder of the general formula SiOx (x = 1.02) having an average particle size of 8 µm. The furnace was evacuated to a pressure below 100 Pa by means of an oil sealed rotary vacuum pump while it was heated to 1,150°C at a ramp of 300°C/hr and held at the temperature. While CH₄ gas was fed at 0.5 NL/min, graphite coating treatment was carried out for 5 hours. A reduced pressure of 2,000 Pa was kept during the treatment. At the end of treatment, the furnace was cooled down, obtaining about 220 g of a black powder.

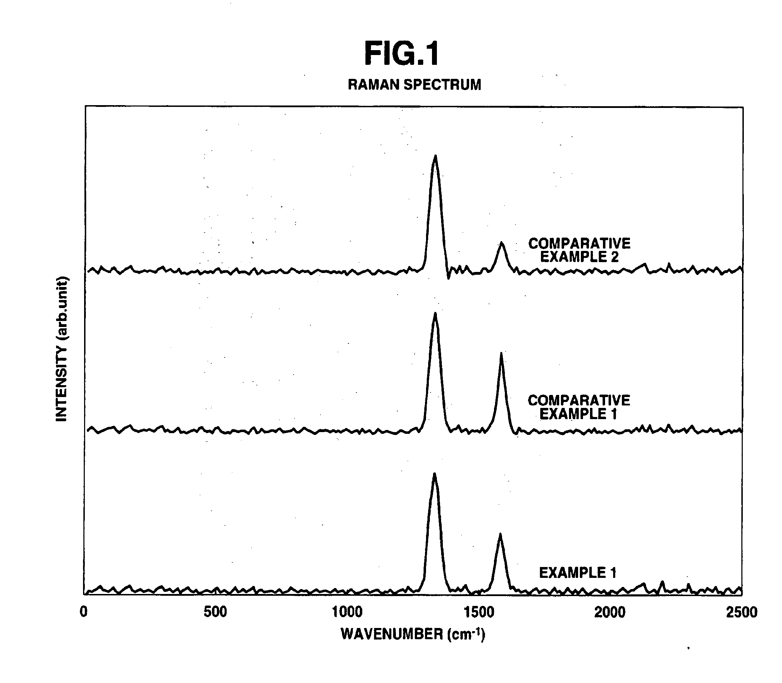

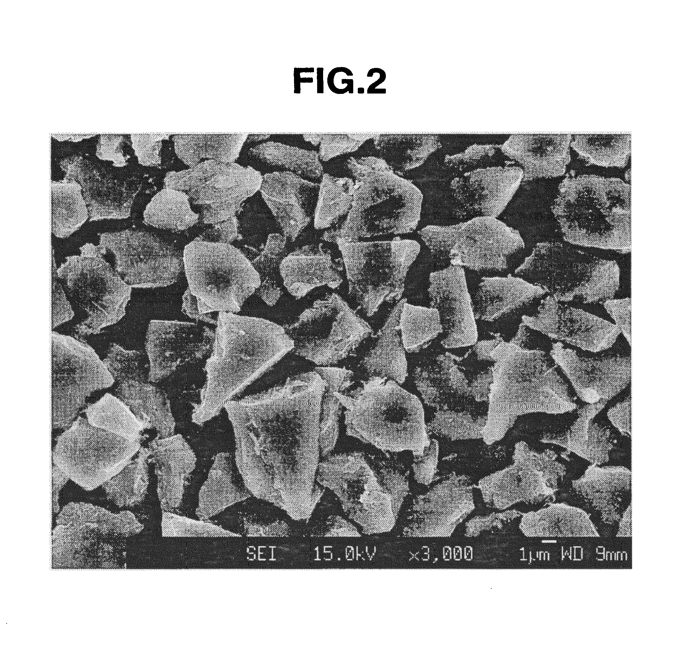

The black powder was a conductive powder having an average particle size of 8.2 µm and a graphite coverage of 12 wt%. The powder was analyzed by microscopic Raman spectroscopy, obtaining a Raman spectrum (FIG. 1) having peaks near 1330 cm⁻¹ and 1580 cm⁻¹ Raman shift, with an intensity ratio I₁₃₃₀/I₁₅₈₀ being 2.0. When the powder was observed under SEM, whiskers were found throughout the field of view (FIG. 2). The whiskers had a length of 0.5 to 3 µm and a diameter of 0.1 to 0.3 µm.

### Cell test

The evaluation of a conductive powder as the negative electrode active material for a lithium ion secondary battery was carried out by the following procedure.

To the conductive powder obtained above, 10 wt% of polyimide was added and N-methylpyrrolidone added to form a slurry. The slurry was coated onto a copper foil of 20 µm gage and dried at 80°C for one hour. Using a roller press, the coated foil was shaped under pressure into an electrode sheet. The electrode sheet was vacuum dried at 350°C for 1 hour, after which 2 cm² discs were punched out as the negative electrode.

To evaluate the charge/discharge performance of the negative electrode, a test lithium ion secondary cell was constructed using a lithium foil as the counter electrode. The electrolyte solution used was a non-aqueous electrolyte solution of lithium hexafluorophosphate in a 1/1 (by volume) mixture of ethylene carbonate and diethyl carbonate in a concentration of 1 mol/liter. The separator used was a microporous polyethylene film of 30 µm thick.

The lithium ion secondary cell thus constructed was allowed to stand overnight at room temperature. Using a secondary cell charge/discharge tester (Nagano K.K.), a charge/discharge test was carried out on the cell. Charging was conducted with a constant current flow of 0.5 mA/cm² until the voltage of the test cell reached 0 V, and after reaching 0 V, continued with a reduced current flow so that the cell voltage was kept at 0 V, and terminated when the current flow decreased below 40 µA/cm². Discharging was conducted with a constant current flow of 0.5 mA/cm² and terminated when the cell voltage rose above 2.0 V, from which a discharge capacity was determined.

By repeating the above operation, the charge/discharge test was carried out 50 cycles on the lithium ion secondary cell. The cell marked an initial charge capacity of 1,885 mAh/g, an initial discharge capacity of 1,526 mAh/g, an initial charge/discharge efficiency of 81%, a 50-th cycle discharge capacity of 1,404 mAh/g, and a cycle retentivity of 92% after 50 cycles, indicating a high capacity. It was a lithium ion secondary cell having improved initial charge/discharge efficiency and cycle performance.

### Comparative Example 1

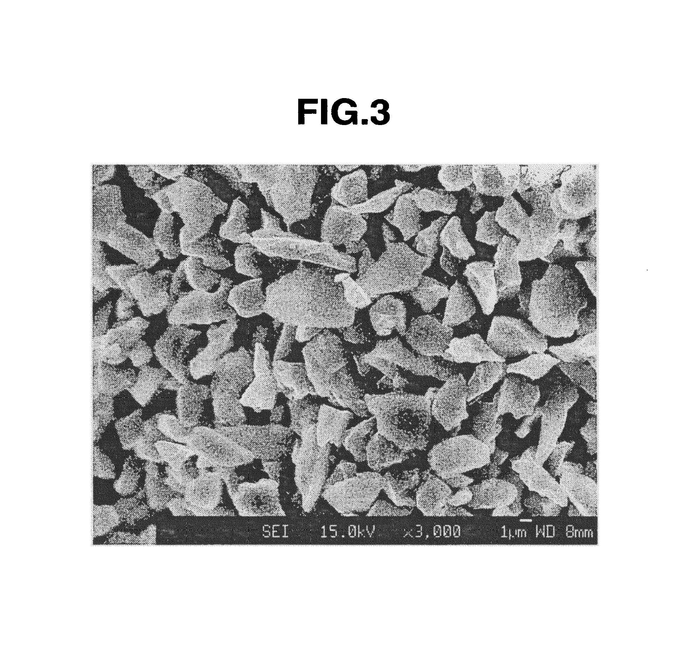

As in Example 1, about 220 g of a conductive powder was prepared as in Example 1 except that graphite coating treatment was carried out on a silicon oxide powder of the general formula SiOx (x = 1.02), while feeding a mixture of Ar and CH₄ at a rate of 2.0 and 0.5 NL/min, under atmospheric pressure without operating the oil sealed rotary vacuum pump. The conductive powder had an average particle size of 8.5 µm and a graphite coverage of 12 wt%. The powder was analyzed by microscopic Raman spectroscopy, obtaining a Raman spectrum (FIG. 1) having peaks near 1330 cm⁻¹ and 1580 cm⁻¹ Raman shift, with an intensity ratio I₁₃₃₀/I₁₅₈₀ being 1.4. When the powder was observed under SEM, no whiskers were found (FIG. 3).

Using this conductive powder, a test lithium ion secondary cell was constructed as in Example 1. By a similar cell test, the cell showed an initial charge capacity of 1,870 mAh/g, an initial discharge capacity of 1,458 mAh/g, an initial charge/discharge efficiency of 78%, a 50-th cycle discharge capacity of 1,265 mAh/g, and a cycle retentivity of 87% after 50 cycles. It was a lithium ion secondary cell having inferior initial charge/discharge efficiency and cycle performance to the cell of Example 1.

### Comparative Example 2

As in Example 1, about 220 g of a conductive powder was prepared as in Example 1 except that graphite coating treatment was carried out on a silicon oxide powder of the general formula SiOx (x = 1.02) under a reduced pressure of 30 Pa by operating a mechanical booster pump instead of the oil sealed rotary vacuum pump. The conductive powder had an average particle size of 8.5 µm and a graphite coverage of 11 wt%. The powder was analyzed by microscopic Raman spectroscopy, obtaining a Raman spectrum (FIG. 1) having peaks near 1330 cm⁻¹ and 1580 cm⁻¹ Raman shift, with an intensity ratio I₁₃₃₀/I₁₅₈₀ being 3.8.

Using this conductive powder, a test lithium ion secondary cell was constructed as in Example 1. By a similar cell test, the cell showed an initial charge capacity of 1,870 mAh/g, an initial discharge capacity of 1,510 mAh/g, an initial charge/discharge efficiency of 81%, a 50-th cycle discharge capacity of 1,150 mAh/g, and a cycle retentivity of 76% after 50 cycles. It was a lithium ion secondary cell having equivalent initial charge/discharge efficiency and inferior cycle performance, as compared with the cell of Example 1.

In respect of numerical ranges disclosed herein it will of course be understood that in the normal way the technical criterion for the upper limit is different from the technical criterion for the lower limit, i.e. the upper and lower limits are intrinsically distinct proposals.

## Claims

1. A negative electrode material suitable for non-aqueous electrolyte secondary batteries, comprising a conductive powder of particles of a lithium ion-occluding and releasing material coated on their surface with a graphite coating, wherein
said graphite coating, on Raman spectroscopy analysis, develops peaks having an intensity I₁₃₃₀ and I₁₅₈₀ at 1330 cm⁻¹ and 1580 cm⁻¹ Raman shift, an intensity ratio I₁₃₃₀/I₁₅₈₀ being 1.5 < I₁₃₃₀/I₁₅₈₀ < 3.0.

2. A negative electrode material of claim 1 wherein the lithium ion-occluding and releasing material is silicon, composite particles having silicon grains dispersed in a silicon compound, silicon oxide of the general formula SiOₓ wherein 0.5 ≤ x < 1.6, or a mixture thereof.

3. A negative electrode material of claim 1 or 2
wherein particles of the lithium ion-occluding and releasing material have whiskers on their surface.

4. A method of preparing a negative electrode material of claim 1 or 3, comprising effecting chemical vapor deposition in an organic gas and/or vapor under a reduced pressure of 50 Pa to 30,000 Pa and at a temperature of 1,000 to 1,400°C on particles of a lithium ion-occluding and releasing material, thereby coating the particles on their surface with a graphite coating.

5. A method of claim 4 wherein the lithium
ion-occluding and releasing material is silicon, composite particles having silicon grains dispersed in a silicon compound, silicon oxide of the general formula SiOₓ wherein 0.5 s x < 1.6, or a mixture thereof.

6. A lithium ion secondary battery comprising a negative electrode material of claim 1, 2 or 3.

7. An electrochemical capacitor comprising a negative electrode material of claim 1, 2 or 3.

## Patentansprüche

1. Material für eine negative Elektrode, das für Sekundärbatterien mit nicht wässrigem Elektrolyt geeignet ist und ein leitfähiges Pulver aus Teilchen eines Lithiumionen okkludierenden und freisetzenden Materials, deren Oberfläche mit einem Graphitüberzug überzogen ist, umfasst, worin
der Graphitüberzug laut Analyse durch Raman-Spektroskopie Peaks mit einer Intensität I₁₃₃₀ und I₁₅₈₀ bei einer Raman-Verschiebung von 1330 cm⁻¹ bzw. 1580 cm⁻¹ entwickelt, wobei das Intensitätsverhältnis I₁₃₃₀/I₁₅₈₀ bei 1,5 < I₁₃₃₀/I₁₅₈₀ < 3,0 liegt.

2. Material für eine negative Elektrode nach Anspruch 1, worin das Lithiumionen okkludierende und freisetzende Material Silicium, Verbundteilchen mit in einer Siliciumverbindung dispergierten Siliciumkörnchen, Siliciumoxid der allgemeinen Formel SiOₓ, worin 0,5 ≤ x < 1,6 ist, oder ein Gemisch davon ist.

3. Material für eine negative Elektrode nach Anspruch 1 oder 2, worin Teilchen des Lithiumionen okkludierenden und freisetzenden Materials Whisker an ihrer Oberfläche aufweisen.

4. Verfahren zur Herstellung eines Materials für eine negative Elektrode nach Anspruch 1 oder 3, das das Bewirken von chemischer Gasphasenabscheidung in einem organischen Gas und/oder Dampf unter reduziertem Druck von 50 Pa bis 30.000 Pa und bei einer Temperatur von 1.000 bis 1.400 °C an Teilchen eines Lithiumionen okkludierenden und freisetzenden Materials umfasst, wodurch die Oberflächen der Teilchen mit einem Graphitüberzug überzogen werden.

5. Verfahren nach Anspruch 4, worin das Lithiumionen okkludierende und freisetzende Material Silicium, Verbundteilchen mit in einer Siliciumverbindung dispergierten Siliciumkörnchen, Siliciumoxid der allgemeinen Formel SiOₓ, worin 0,5 ≤ x < 1,6 ist, oder ein Gemisch davon ist.

6. Sekundäre Lithiumionenbatterie, die ein Material für eine negative Elektrode nach Anspruch 1, 2 oder 3 umfasst.

7. Elektrochemischer Kondensator, der ein Material für eine negative Elektrode nach Anspruch 1, 2 oder 3 umfasst.

## Revendications

1. Matériau d'électrode négative adapté pour batteries secondaires à électrolyte non aqueux, comprenant une poudre conductrice de particules d'un matériau d'occlusion et de libération d'ions lithium enduite sur leur surface avec un revêtement de graphite, dans lequel
ledit revêtement de graphite, en analyse par spectroscopie Raman, développe des pics ayant une intensité I₁₃₃₀ et I₁₅₈₀ à 1330 cm⁻¹ et 1580 cm⁻¹ de déplacement Raman, un rapport d'intensité I₁₃₃₀/I₁₅₈₀ étant 1,5 < I₁₃₃₀/I₁₅₈₀ < 3,0.

2. Matériau d'électrode négative de la revendication 1 dans lequel le matériau d'occlusion et de libération d'ions lithium est le silicium, des particules composites ayant des grains de silicium dispersés dans un composé de silicium, de l'oxyde de silicium de formule générale SiOₓ dans laquelle 0,5 ≤ x < 1,6, ou un mélange de ceux-ci.

3. Matériau d'électrode négative de la revendication 1 ou 2 dans lequel les particules du matériau d'occlusion et de libération d'ions lithium comportent des barbes sur leur surface.

4. Procédé de préparation d'un matériau d'électrode négative de la revendication 1 ou 3, comprenant la conduite d'un dépôt chimique en phase vapeur dans un gaz organique et/ou une vapeur sous une pression réduite de 50 Pa à 30 000 Pa et à une température de 1000 à 1400 °C sur des particules d'un matériau d'occlusion et de libération de lithium, de manière à enrober les particules sur leur surface avec un revêtement de graphite.

5. Procédé de la revendication 4 dans lequel le matériau d'occlusion et de libération d'ions lithium est le silicium, des particules composites ayant des grains de silicium dispersés dans un composé de silicium, de l'oxyde de silicium de formule générale SiOₓ dans laquelle 0,5 ≤ x < 1,6, ou un mélange de ceux-ci.

6. Batterie secondaire au lithium-ion comprenant un matériau d'électrode négative de la revendication 1, 2 ou 3.

7. Condensateur électrochimique comprenant un matériau d'électrode négative de la revendication 1, 2 ou 3.
